(19) Europäisches Patentamt / European Patent Office / Office européen des brevets

(11) **EP 2 751 221 B1**

(12) **FASCICULE DE BREVET EUROPEEN**

(45) Date de publication et mention
de la délivrance du brevet:
**02.08.2017 Bulletin 2017/31**

(21) Numéro de dépôt: **12748699.1**

(22) Date de dépôt: **21.08.2012**

(51) Int Cl.:
*C09K 11/77* *(2006.01)*     *H01J 1/63* *(2006.01)*
*H01L 33/50* *(2010.01)*

(86) Numéro de dépôt international:
**PCT/EP2012/066259**

(87) Numéro de publication internationale:
**WO 2013/030044 (07.03.2013 Gazette 2013/10)**

(54) **LUMINOPHORE A BASE D'UN PHOSPHATE DE LANTHANE, DE CERIUM ET DE TERBIUM A BRILLANCE STABILISEE, PROCEDE DE PREPARATION ET UTILISATION DANS UN DISPOSITIF LUMINESCENT**

PHOSPHOR AUF BASIS EINES LANTHAN-CER-TERBIUMPHOSPHATS MIT STABILISIERTER HELLIGKEIT, HERSTELLUNGSVERFAHREN DAFÜR UND SEINE VERWENDUNG IN EINER LUMINESZIERENDEN VORRICHTUNG

PHOSPHOR BASED ON A LANTHANUM CERIUM TERBIUM PHOSPHATE WITH STABILIZED BRIGHTNESS, PREPARATION PROCESS AND USE IN A LUMINESCENT DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.08.2011 FR 1102643**

(43) Date de publication de la demande:
**09.07.2014 Bulletin 2014/28**

(73) Titulaire: **Rhodia Operations**
**75009 Paris (FR)**

(72) Inventeurs:
• **BUISSETTE, Valérie**
  **F-75015 Paris (FR)**
• **LE-MERCIER, Thierry**
  **F-93110 Rosny-sous-Bois (FR)**

(74) Mandataire: **Senninger, Thierry**
  **Rhodia Operations**
  **Département de la Propriété Industrielle**
  **40, rue de la Haie-Coq**
  **93306 Aubervilliers Cedex (FR)**

(56) Documents cités:
**EP-A1- 0 581 621**     **EP-A1- 0 685 549**
**CN-A- 101 270 285**     **US-A- 5 651 920**

**Description**

La présente invention concerne un luminophore à base d'un phosphate de lanthane, de cérium et de terbium à brillance stabilisée, son procédé de préparation et son utilisation dans un dispositif luminescent.

Les phosphates mixtes de lanthane, de cérium et de terbium sont bien connus pour leurs propriétés de luminescence. Ils émettent une vive lumière verte lorsqu'ils sont irradiés par certains rayonnements énergétiques de longueurs d'ondes inférieures à celles du domaine visible (rayonnements UV ou VUV pour les systèmes d'éclairage ou de visualisation). Des luminophores exploitant cette propriété sont couramment utilisés à l'échelle industrielle, par exemple dans des lampes fluorescentes trichromatiques, dans des systèmes de rétroéclairage pour afficheurs à cristaux liquides ou dans des systèmes plasma.

On cherche toujours par ailleurs à obtenir des luminophores dont les propriétés soient améliorées et notamment les propriétés de mise en oeuvre de ces produits. Ainsi, lors de la fabrication des dispositifs luminescents, les luminophores qui sont utilisés sont soumis à des températures élevées ce qui peut entrainer une dégradation de leurs propriétés de luminescence, notamment de leur brillance.

Il y a ainsi un besoin pour des luminophores dont la brillance reste stable même après calcination et durant leur fonctionnement dans les dispositifs luminescents.

Un objet de l'invention est de proposer un luminophore répondant à ce besoin.

Dans ce but, le luminophore de l'invention est à base d'un phosphate de lanthane, de cérium et de terbium, et il est caractérisé en ce que le phosphate est constitué de particules de taille moyenne d'au plus 4 $\mu$m, en ce qu'il présente une teneur en lithium d'au plus 30 ppm, une teneur en bore d'au plus 30 ppm et en ce qu'il présente une variation de brillance entre la brillance mesurée sur le luminophore à 25°C et celle mesurée sur le même luminophore à 200°C d'au plus 4%.

L'invention concerne aussi un procédé de préparation d'un tel luminophore, ce procédé étant caractérisé en ce qu'il comprend les étapes suivantes :

a) on introduit, en continu et sous agitation, une première solution contenant des sels solubles des éléments lanthane, cérium et terbium dans une seconde solution contenant des ions phosphates et présentant un pH initial inférieur à 2, ce par quoi on forme un précipité, et on contrôle au cours de l'introduction de la première solution dans la seconde, le pH du milieu de précipitation à une valeur constante et inférieure à 2;

b) on récupère le précipité ainsi obtenu;

c) on calcine le précipité à une température d'au plus 1000°C;

d) on traite thermiquement le précipité issu de l'étape c) sous atmosphère réductrice, en présence de tétraborate de lithium ($Li_2B_4O_7$) dans une quantité massique d'au plus 0,2%, à une température comprise entre 1050°C et 1150°C et sur une durée comprise entre 2 heures et 4 heures.

D'autres caractéristiques, détails et avantages de l'invention apparaîtront encore plus complètement à la lecture de la description qui va suivre ainsi que des divers exemples concrets mais non limitatifs destinés à l'illustrer.

On précise aussi pour la suite de la description que, sauf indication contraire, dans toutes les gammes ou limites de valeurs qui sont données, les valeurs aux bornes sont incluses, les gammes ou limites de valeurs ainsi définies couvrant donc toute valeur au moins égale et supérieure à la borne inférieure et/ou au plus égale ou inférieure à la borne supérieure.

Comme indiqué plus haut, le luminophore est à base d'un phosphate de lanthane, de cérium et de terbium, de type orthophosphate de formule $LnPO_4$, Ln désignant les élements lanthane, cérium et terbium.

Selon un mode de réalisation plus particulier de l'invention, le luminophore est constitué essentiellement, la présence d'autres espèces phosphatées résiduelles étant en effet possible et, préférentiellement, totalement ou uniquement du phosphate précité.

Le phosphate du luminophore de l'invention présente une structure cristalline de type monazite. Cette structure cristalline peut être mise en évidence par la technique de diffraction aux rayons X (DRX). Selon une variante préférentielle, les luminophores de l'invention sont phasiquement purs, c'est-à-dire que les diagrammes DRX ne font apparaître que la seule et unique phase monazite. Néanmoins, les luminophores de l'invention peuvent aussi ne pas être phasiquement purs et dans ce cas, les diagrammes DRX des produits montrent la présence de phases résiduelles très minoritaires.

Plus particulièrement, le phosphate de lanthane, de cérium et de terbium peut répondre à la formule $(La_xCe_yTb_z)PO_4$ (1) dans laquelle x, y et z vérifient les formules :

$$x + y + z = 1$$

$$0,2 \leq y \leq 0,45$$

$$0,1 \leq z \leq 0,2.$$

Plus particulièrement y peut vérifier la relation $0,2 \leq y \leq 0,35$ et z la relation $0,13 \leq z \leq 0,16$.

Selon une autre caractéristique du luminophore de l'invention le phosphate de lanthane, de cérium et de terbium est constitué de particules dont la taille moyenne ou le diamètre moyen est d'au plus 4 μm, plus particulièrement d'au plus 3,5 μm et encore plus particulièrement d'au plus 3,2 μm. Ce diamètre moyen peut notamment être compris entre 2,5 μm et 4 μm et plus particulièrement entre 2,5 μm et 3,5 μm.

Le diamètre moyen auquel il est fait référence est la moyenne en volume des diamètres d'une population de particules.

Les particules auxquelles il est fait référence ici peuvent être des agrégats d'autres particules plus fines, agrégées, appelées « particules primaires ». Pour la suite de la description le terme « particule » ne s'applique pas à ces particules primaires mais à celles mentionnées précédemment et de diamètre moyen est d'au plus 4 μm, ceci sauf indication contraire.

Les valeurs de granulométrie données ici et pour le reste de la description sont mesurées par la technique de granulométrie laser, par exemple au moyen d'un granulométre laser de type Malvern, sur un échantillon de particules dispersées dans l'eau aux ultrasons (130 W) pendant 1 minute 30 secondes.

Par ailleurs, les particules ont de préférence un faible indice de dispersion, typiquement d'au plus 0,7, plus particulièrement d'au plus 0,6 et encore plus particulièrement d'au plus 0,5.

Par "indice de dispersion" d'une population de particules, on entend, au sens de la présente description, le rapport I tel que défini ci-dessous :

$$I=(D_{84}- D_{16})/(2x\ D_{50}),$$

où : $D_{84}$ est le diamètre des particules pour lequel 84% des particules ont un diamètre inférieur à $D_{84}$; $D_{16}$ est le diamètre des particules pour lequel 16% des particules ont un diamètre inférieur à $D_{16}$; et $D_{50}$ est le diamètre moyen des particules, diamètre pour lequel 50% des particules ont un diamètre inférieur à $D_{50}$.

Le luminophore de l'invention est aussi caractérisé par sa teneur en lithium et en bore.

Cette teneur en lithium est d'au plus 30 ppm, notamment d'au plus 20 ppm. Elle peut être plus particulièrement d'au plus 15 ppm.

Par ailleurs le luminophore de l'invention présente une teneur en bore d'au plus 30 ppm, plus particulièrement d'au plus 20 ppm et encore plus particulièrement 15 ppm.

On notera qu'ici et pour l'ensemble de la description, la teneur en lithium et en bore est mesurée par la technique ICP (Inductively Coupled Plasma) - AES (Atomic Emission Spectroscopy) ou ICP - OES (Optical Emission Spectroscopy) et après attaque complète du produit.

Une autre caractéristique particulièrement intéressante du luminophore de l'invention est sa brillance.

Cette brillance est stable. On entend par là qu'elle ne varie pas d'une manière significative en température. Plus précisément la variation est d'au plus 4% entre la brillance ($B_{25}$) mesurée pour le luminophore à 25°C et la brillance ($B_{200}$) de ce luminophore mesurée à 200°C ($[B_{25} - B_{200}]/ B_{25} \leq 0,04$). Cette variation de la brillance peut être plus particulièrement d'au plus 3% et encore plus particulièrement d'au plus 2%.

La brillance d'un luminophore peut être quantifiée par le rendement de conversion du luminophore, qui correspond à un rapport entre le nombre de photons émis par un luminophore et le nombre de photons qui constitue le faisceau d'excitation. Le rendement de conversion d'un luminophore est évalué par mesure dans la gamme visible du spectre électromagnétique de l'émission d'un luminophore sous une excitation dans le domaine UV ou VUV généralement à une longueur d'onde inférieure à 280 nm. La valeur de brillance est obtenue en intégrant l'intensité d'émission entre 400 nm et 780 nm.

Selon des modes de réalisation particuliers de l'invention, le luminophore est à base d'un phosphate de lanthane, de cérium et de terbium qui présente une teneur spécifique en sodium ou en potassium ainsi qu'une structure cristalline de type monazite.

Plus précisément et selon une première variante des modes de réalisation particuliers mentionnés ci-dessus, les luminophores de l'invention sont à base d'un phosphate de type précité et ils contiennent du potassium dans une teneur d'au plus 350 ppm. Cette teneur est exprimée en masse d'élément potassium par rapport à la masse totale du phosphate.

La teneur minimale en potassium peut correspondre à la valeur minimale détectable par la technique d'analyse utilisée pour mesurer la teneur en potassium. Toutefois, généralement cette teneur minimale est d'au moins 10 ppm, plus particulièrement d'au moins 40 ppm et encore plus particulièrement d'au moins 50 ppm. Cette teneur en potassium peut être plus particulièrement comprise entre une valeur égale ou supérieure à 100 ppm et d'au plus 350 ppm ou encore entre une valeur supérieure à 200 ppm et 350 ppm.

Selon une variante particulière le luminophore ne contient pas d'autre élément que le potassium en tant qu'élément alcalin et éventuellement du lithium.

Selon une seconde variante des modes de réalisation particuliers mentionnés ci-dessus, les luminophores de l'invention sont à base d'un phosphate de type précité et ils contiennent du sodium dans une teneur d'au plus 350 ppm, plus particulièrement d'au plus 250 ppm et encore plus particulièrement d'au plus 100 ppm. Cette teneur est exprimée, là aussi, en masse d'élément sodium par rapport à la masse totale du phosphate.

La teneur minimale en sodium peut aussi correspondre à la valeur minimale détectable par la technique d'analyse utilisée pour mesurer la teneur en sodium. Toutefois, généralement cette teneur est d'au moins 10 ppm et plus particulièrement d'au moins 50 ppm.

Selon une variante particulière le luminophore ne contient pas d'autre élément que le sodium en tant qu'élément alcalin et éventuellement du lithium.

Il est précisé aussi ici et pour l'ensemble de la description que la mesure de la teneur en potassium ou en sodium est faite selon deux techniques. La première est la technique de fluorescence X et elle permet de mesurer des teneurs en potassium ou en sodium qui sont d'au moins 100 ppm environ. Cette technique sera utilisée plus particulièrement pour les luminophores pour lesquels les teneurs en potassium ou en sodium sont les plus élevées. La seconde technique est la technique ICP (Inductively Coupled Plasma) - AES (Atomic Emission Spectroscopy) ou ICP - OES (Optical Emission Spectroscopy). Cette technique sera utilisée plus particulièrement ici pour les les luminophores pour lesquels les teneurs en potassium ou en sodium sont les plus faibles, notamment pour les teneurs inférieures à environ 100 ppm.

Le procédé de préparation du luminophore de l'invention va maintenant être décrit.

Selon l'invention, dans une première étape (a) on réalise une précipitation directe et à pH contrôlé d'un phosphate de lanthane, de cérium et de terbium, et ceci en faisant réagir une première solution contenant des sels des éléments lanthane, cérium et terbium, éléments Ln, ces sels étant alors présents dans les proportions requises pour l'obtention du produit de composition désirée, avec une deuxième solution contenant des ions phosphates.

Selon une première caractéristique importante du procédé, un certain ordre d'introduction des réactifs doit être respecté, et, plus précisément encore, la solution des sels des éléments Ln doit être introduite, progressivement et en continu, dans la solution contenant les ions phosphates.

Selon une deuxième caractéristique importante du procédé selon l'invention, le pH initial de la solution contenant les ions phosphates doit être inférieur à 2, et de préférence compris entre 1 et 2.

Selon une troisième caractéristique, le pH du milieu de précipitation doit ensuite être contrôlé à une valeur de pH inférieure à 2, et de préférence comprise entre 1 et 2.

Par "pH contrôlé", on entend un maintien du pH du milieu de précipitation à une certaine valeur, constante ou sensiblement constante, par addition d'un composé basique dans la solution contenant les ions phosphates, et ceci simultanément à l'introduction dans cette dernière de la solution contenant les sels des éléments Ln. Le pH du milieu variera ainsi d'au plus 0,5 unité de pH autour de la valeur de consigne fixée, et de préférence encore d'au plus 0,1 unité de pH autour de cette valeur. La valeur de consigne fixée correspondra avantageusement au pH initial (inférieur à 2) de la solution contenant les ions phosphates.

La précipitation est réalisée de préférence en milieu aqueux à une température qui n'est pas critique et qui est comprise, avantageusement, entre la température ambiante (15°C - 25°C) et 100°C. Cette précipitation a lieu sous agitation du milieu de réaction.

Les concentrations des sels des éléments Ln dans la première solution peuvent varier dans de larges limites. Ainsi, la concentration totale en ces sels d'éléments peut être comprise entre 0,01 mol/litre et 3 mol/litre.

Les sels des éléments Ln convenables pour l'invention sont notamment les sels solubles en milieu aqueux, comme par exemple les nitrates, chlorures, acétates, carboxylates, ou un mélange de ceux-ci.

Les ions phosphates destinés à réagir avec la solution des sels des éléments Ln peuvent être apportés par des composés purs ou en solution, comme par exemple l'acide phosphorique, les phosphates d'alcalins ou d'autres éléments métalliques donnant un composé soluble avec les anions associés aux éléments Ln.

Les ions phosphates sont présents en quantité telle que l'on ait, entre les deux solutions, un rapport molaire $PO_4$/Ln supérieur à 1, et avantageusement compris entre 1,1 et 3.

Comme souligné ci-avant dans la description, la solution contenant les ions phosphates doit présenter initialement (c'est à dire avant le début de l'introduction de la solution de sels d'éléments Ln) un pH inférieur à 2, et de préférence compris entre 1 et 2. Aussi, si la solution utilisée ne présente pas naturellement un tel pH, ce dernier est amené à la valeur convenable désirée soit par ajout d'un composé basique, soit par ajout d'un acide (par exemple de l'acide chlorhydrique, dans le cas d'une solution initiale à pH trop élevé).

Par la suite, au cours de l'introduction de la solution contenant les sels d'éléments Ln, le pH du milieu de précipitation diminue progressivement; aussi, selon l'une des caractéristiques du procédé selon l'invention, dans le but de maintenir le pH du milieu de précipitation à la valeur constante de travail désirée, laquelle doit être inférieure à 2 et de préférence comprise entre 1 et 2, on introduit simultanément dans ce milieu un composé basique.

Comme composé basique convenable pour l'invention, on peut citer, à titre d'exemples, les hydroxydes métalliques (NaOH, KOH, Ca(OH)$_2$,....) ou l'hydroxyde d'ammonium, ou tout autre composé basique dont les espèces le constituant ne formeront aucun précipité lors de leur addition dans le milieu réactionnel, par combinaison avec une des espèces par ailleurs contenues dans ce milieu, et permettant un contrôle du pH du milieu de précipitation.

Selon un mode préféré de réalisation de l'invention, ce composé basique est avantageusement un composé facilement éliminable soit avec la phase liquide du milieu réactionnel et lavage du précipité, soit par décomposition thermique lors de la calcination du phosphate.

Ainsi, le composé basique préféré de l'invention est l'ammoniac, qui est mis en oeuvre avantageusement sous forme de solution aqueuse.

A l'issue de la précipitation il est possible éventuellement d'effectuer un mûrissement en maintenant le milieu réactionnel obtenu précédemment à une température située dans la même gamme de température que celle à laquelle la précipitation a eu lieu et pendant une durée qui peut être comprise entre un quart d'heure et une heure par exemple.

Dans l'étape suivante (b), le précipité peut être récupéré par tout moyen connu en soi, en particulier par simple filtration. En effet, dans les conditions du procédé selon l'invention, on précipite un composé contenant un phosphate non gélatineux et filtrable.

Le produit récupéré est ensuite lavé, par exemple avec de l'eau, puis séché.

Dans l'étape suivante (c), le produit est soumis à un premier traitement thermique ou une première calcination.

Généralement la température de calcination est d'au plus 1000°C, plus particulièrement d'au plus 900°C environ et elle est d'au moins 650°C.

La durée de calcination est généralement d'autant plus faible que la température est élevée. A titre d'exemple uniquement, cette durée peut être comprise entre 1 et 3 heures, cette durée s'entendant comme une durée en palier à la température donnée précédemment.

Cette première calcination se fait généralement sous air.

On obtient à l'issue de ce premier traitement thermique un produit qui peut être considéré comme un précurseur du luminophore de l'invention dans la mesure où ce précurseur ne présente pas de propriétés de luminescence suffisantes d'un point de vue commercial.

Pour obtenir le luminophore de l'invention, ce précurseur doit subir un deuxième traitement thermique.

Ce deuxième traitement thermique est conduit en général sous atmosphère réductrice ($H_2$, $N_2/H_2$ ou $Ar/H_2$ par exemple).

Selon une caractéristique essentielle de l'invention il se fait en présence d'un flux, ou agent fondant, qui est le tétraborate de lithium ($Li_2B_4O_7$). L'agent fondant est mélangé avec le précurseur à traiter dans une quantité de tétraborate qui est d'au plus 0,2% en masse de tétraborate par rapport à l'ensemble agent fondant + précurseur. Cette quantité peut être plus particulièrement comprise entre 0,1 et 0,2%.

La température du traitement est comprise entre 1050°C et 1150°C. La durée du traitement est comprise entre 2 et 4 heures, cette durée s'entendant comme une durée en palier à la température donnée précédemment.

Après traitement, les particules sont avantageusement lavées, de manière à obtenir un luminophore le plus pur possible et dans un état désaggloméré ou faiblement aggloméré. Dans ce dernier cas, il est possible de désagglomérer le luminophore en lui faisant subir un traitement de désagglomération dans des conditions douces, par exemple en utilisant un broyeur à boulets.

Toutefois et selon une variante avantageuse du procédé de l'invention, le produit issu du deuxième traitement thermique peut être redispersé dans de l'eau chaude.

Cette redispersion se fait en introduisant le produit solide dans l'eau et sous agitation. La suspension ainsi obtenue est maintenue sous agitation pendant une durée qui peut être comprise entre 1 et 6 heures environ, plus particulièrement entre 1 et 3 heures environ.

La température de l'eau peut être d'au moins 30°C, plus particulièrement d'au moins 60°C et elle peut être comprise entre environ 30°C et 90°C, de préférence entre 60°C et 90°C, sous pression atmosphérique. Le produit solide en suspension est ensuite séparé du milieu liquide par tout moyen connu. Il peut être ensuite lavé et/ou séché. Si nécessaire, le produit peut enfin être désaggloméré comme décrit plus haut.

On peut noter que le second traitement thermique selon le procédé de l'invention induit une variation faible entre la taille des particules du précurseur et celles du luminophore. Cette variation est généralement d'au plus 20%, plus particulièrement d'au plus 10%. De ce fait il n'est pas nécessaire de broyer le luminophore pour ramener sa taille moyenne de particule à la taille moyenne des particule du précurseur de départ.

L'absence de broyage ou la mise en oeuvre d'une simple désagglomération dans le procédé de préparation des luminophores permet d'obtenir des produits qui ne présentent pas ou peu de défauts de surface ce qui contribue à améliorer les propriétés de luminescence de ces produits. Les clichés MEB des produits montrent en effet que leur surface est substantiellement lisse. En particulier, ceci a pour effet de limiter l'interaction des produits avec le mercure lorsque ceux-ci sont mis en oeuvre dans des lampes à vapeur de mercure et donc de constituer un avantage dans leur utilisation.

On va décrire ci-après les procédés de préparation des luminophores selon les modes de réalisation particuliers mentionnés plus haut, c'est-à-dire ceux à base d'un phosphate de structure de type monazite et qui contient du sodium ou du potassium.

Ces procédés sont pour l'essentiel similaires à celui plus général qui a été décrit plus haut. Ce qui a été décrit précédemment pour ce procédé général s'applique donc aussi ici avec néanmoins les différences qui vont être mentionnées ci-dessous.

Ainsi et dans le cas de la préparation d'un luminophore à base d'un phosphate contenant du potassium on utilise des chlorures comme sels des éléments Ln pour l'étape (a) décrite plus haut. Par aileurs, le composé basique qui est utilisé soit pour amener le pH initial de la seconde solution contenant les ions phosphates à une valeur inférieure à 2 soit pour le contrôle du pH lors de la précipitation est, au moins en partie, de la potasse. Par « au moins en partie » on entend qu'il est possible d'utiliser un mélange de composés basiques dont au moins un est de la potasse. L'autre composé basique peut être par exemple de l'ammoniaque. Selon un mode de réalisation préférentiel on utilise un composé basique qui est uniquement la potasse et selon un autre mode de réalisation encore plus préférentiel on utilise la potasse seule et pour les deux opérations précitées c'est-à-dire à la fois pour amener le pH de la seconde solution à la valeur convenable et pour le contrôle du pH de précipitation. Dans ces deux derniers modes de réalisation préférentiels on diminue ou on supprime le rejet de produits azotés qui pourraient être apportés par un composé basique comme l'ammoniaque.

Une autre différence de ce procédé particulier par rapport au procédé général décrit plus haut réside dans le fait que le produit issu de la première calcination est ensuite redispersé dans de l'eau chaude.

Cette redispersion se fait en introduisant le produit solide dans l'eau et sous agitation. La suspension ainsi obtenue est maintenue sous agitation pendant une durée qui peut être comprise entre 1 et 6 heures environ, plus particulièrement entre 1 et 3 heures environ.

La température de l'eau peut être d'au moins 30°C, plus particulièrement d'au moins 60°C et elle peut être comprise entre environ 30°C et 90°C, de préférence entre 60°C et 90°C, sous pression atmosphérique. Il est possible de conduire cette opération sous pression, par exemple dans un autoclave, à une température qui peut être alors comprise entre 100°C et 200°C, plus particulièrement entre 100°C et 150°C.

Dans une dernière étape on sépare par tout moyen connu en soi, par exemple par simple filtration, le solide du milieu liquide. Il est possible éventuellement de répéter, une ou plusieurs fois, l'étape de redispersion dans les conditions décrites plus haut, éventuellement à une température différente de celle à laquelle a été conduite la première redispersion.

Pour la préparation d'un luminophore à base d'un phosphate contenant du sodium, là encore le procédé utilisé est similaire au procédé général décrit plus haut mais avec comme première différence la mise en oe uvre à l'étape (a) de chlorures comme sels des éléments Ln. Par aileurs, le composé basique qui est utilisé soit pour amener le pH initial de la seconde solution contenant les ions phosphates à une valeur inférieure à 2 soit pour le contrôle du pH lors de la précipitation est, au moins en partie, de la soude. Par « au moins en partie » on entend qu'il est possible d'utiliser un mélange de composés basiques dont au moins un est de la soude. L'autre composé basique peut être par exemple de l'ammoniaque. Selon un mode de réalisation préférentiel on utilise un composé basique qui est uniquement la soude et selon un autre mode de réalisation encore plus préférentiel on utilise la soude seule et pour les deux opérations précitées c'est-à-dire à la fois pour amener le pH de la seconde solution à la valeur convenable et pour le contrôle du pH de précipitation. Dans ces deux derniers modes de réalisation préférentiels on diminue ou on supprime le rejet de produits azotés qui pourraient être apportés par un composé basique comme l'ammoniaque.

Enfin, comme dans le cas de la préparation de luminophore contenant du potassium, le produit issu de la première calcination est ensuite redispersé dans de l'eau chaude. Ce qui a été décrit plus haut pour cette redispersion s'applique de même ici.

L'invention concerne aussi un luminophore à base d'un phosphate de lanthane, de cérium et de terbium, ce phosphate étant constitué de particules de taille moyenne d'au plus 4 $\mu$m et présentant une teneur en lithium d'au plus 30 ppm, une teneur en bore d'au plus 30 ppm et ce luminophore est susceptible d'être obtenu par le procédé de préparation qui vient d'être décrit ci-dessus.

Ce luminophore présente toutes les caractéristiques techniques qui ont été données précédemment dans la description notamment les caractéristiques cristallographiques, de compositions (voir notamment la formule (1) ci-dessus), de tailles de particules et d'indice de dispersion. Il présente aussi la stabilité de brillance décrite plus haut c'est-à-dire une variation de brillance ([$B_{25}$ - $B_{200}$]/ $B_{25}$ d'au plus 0,4. Par ailleurs tout ce qui a été décrit pour le procédé de préparation s'applique de même ici pour la définition de ce luminophore.

Les luminophores de l'invention présentent des propriétés de luminescence intenses dans le vert pour des excitations électromagnétiques correspondant aux divers domaines d'absorption du produit.

Ainsi, les luminophores de l'invention peuvent être utilisés dans les systèmes d'éclairage ou de visualisation présentant une source d'excitation dans la gamme UV (200 - 280 nm), par exemple autour de 254 nm. On notera en particulier les lampes trichromatiques notamment à vapeur de mercure, les lampes pour rétro-éclairage des systèmes à cristaux liquides, sous forme tubulaire ou planaire (LCD Back Lighting).

Les luminophores de l'invention sont également de bons candidats comme luminophores verts pour les systèmes à excitation VUV (ou "plasma"), que sont par exemple les écrans plasma et les lampes trichromatiques sans mercure, notamment les lampes à excitation Xénon (tubulaires ou planaires).

Les luminophores de l'invention peuvent également être utilisés comme luminophores verts dans des dispositifs à excitation par diode électroluminescente. Ils peuvent être notamment utilisés dans des systèmes excitables dans le proche UV.

Ils peuvent être également utilisés dans des systèmes de marquage à excitation UV.

Les luminophores de l'invention peuvent être mis en oeuvre dans les systèmes de lampes et d'écrans par des techniques bien connues, par exemple par sérigraphie, par électrophorèse ou par sédimentation.

Ils peuvent également être dispersés dans des matrices organiques (par exemple, des matrices plastiques ou des polymères transparents sous UV ...), minérales (par exemple, de la silice) ou hybrides organo-minérales.

L'invention concerne aussi, selon un autre aspect, les dispositifs luminescents du type précité, comprenant les luminophores de l'invention à titre de source de luminescence verte.

Ces dispositifs peuvent être des dispositifs à excitation UV, notamment des lampes trichromatiques, en particulier à vapeur de mercure, des lampes de rétro-éclairage de systèmes à cristaux liquides, des écrans plasma, des lampes à excitation Xénon, des dispositifs à excitation par diodes électroluminescentes et des systèmes de marquage à excitation UV.

Des exemples vont maintenant être donnés.

EXEMPLE 1

Cet exemple concerne la préparation d'un précurseur d'un luminophore selon l'invention.

Dans un bécher de 1 litre, on prépare une solution de nitrates de terres rares (Solution A) comme suit : on mélange 171,5 g d'une solution de La(NO$_3$)$_3$ à 3,0 M, 179,8 g d'une solution de Ce(NO$_3$)$_3$ à 2,88 M, 54,5 g d'une solution de Tb(NO$_3$)$_3$ à 2,57 M et 107,7 mL d'eau permutée, soit un total de 0,7 mol de nitrates de terres rares correspondant à une composition (La$_{0,44}$Ce$_{0,43}$Tb$_{0,13}$)(NO$_3$)$_3$.

Dans un réacteur de 1 litre, on introduit (Solution B), 436 ml d'eau permutée, à laquelle on ajoute 29,4 g de H$_3$PO$_4$ Normapur 85% puis de l'ammoniaque NH$_4$OH 28%, pour atteindre un pH de1,7. La solution est portée à 60°C. La solution A précédemment préparée est ajoutée au mélange, lentement, sous agitation, en température (60°C) et sous régulation de pH à 1,7. Le mélange obtenu est mûri 15 minutes à 60°C. A l'issue du mûrissement, la solution présente un aspect blanc laiteux. On laisse refroidir jusqu'à 30°C. On filtre sur fritté et on lave avec deux litres d'eau, puis on sèche et calcine 2h à 900°C sous air.

On obtient alors un phosphate de terre rare de phase monazite, (La,Ce,Tb)PO$_4$. Les particules présentent un D$_{50}$ de 3,0 $\mu$m, avec un indice de dispersion de 0,5.

EXEMPLE 2

Cet exemple concerne la préparation d'un luminophore selon l'invention.

Le précurseur obtenu à l'exemple 1 est calciné à 1100°C, pendant 4h, sous atmosphère réductrice (Ar/H$_2$), en présence de 0,1% en poids de borate de lithium Li$_2$B$_4$O$_7$ par rapport à la quantité de précurseur (La,Ce,Tb)PO$_4$. Le produit obtenu est ensuite redispersé dans l'eau chaude à 60°C, filtré sur filtre Büchner, puis lavé par 1 L d'eau.

Il est ensuite séché à l'étuve, pendant une nuit à 60°C. Ensuite il est désaggloméré par un traitement au broyeur à boulets de 30 minutes, puis tamisé.

Les particules présentent un D$_{50}$ de 3,2 $\mu$m, avec un indice de dispersion de 0,6.

Le rendement de luminescence est fixé à 100% comme référence.

La teneur en bore mesurée est de 19 ppm, la teneur en lithium mesurée est de 12 ppm.

EXEMPLE 3 COMPARATIF

Cet exemple concerne la préparation d'un luminophore dans laquelle on utilise un autre flux que celui utilisé pour la préparation du luminophore selon l'invention.

Le précurseur obtenu à l'exemple 1 est calciné à 1000°C pendant 3h sous atmosphère réductrice (Ar/H$_2$), en présence de 1% en poids de fluorure de lithium LiF par rapport à la quantité de précurseur (La,Ce,Tb)PO$_4$. Afin de faciliter le délitage du produit obtenu, celui-ci est ensuite redispersé dans une solution à 5% d'acide nitrique, filtré sur filtre Büchner, puis lavé par 5L d'eau. Il est ensuite séché à l'étuve, pendant une nuit à 60°C. Ensuite il est désaggloméré par un traitement au broyeur à boulets de 1 heure, puis tamisé.

Les particules présentent un D$_{50}$ de 4,5 $\mu$m, avec un indice de dispersion de 0,5.

Le rendement de luminescence mesuré à 25°C est de 99% par rapport au produit de l'exemple 2.

EXEMPLE 4 COMPARATIF

Cet exemple concerne la préparation d'un luminophore dans laquelle on utilise un autre flux que celui utilisé pour la préparation du luminophore selon l'invention.

Le précurseur obtenu à l'exemple 1 est calciné à 1000°C pendant 3h, sous atmosphère réductrice (Ar/H$_2$),en présence de 52,3% en poids d'acide borique et de 0,85% de Li$_2$CO$_3$ par rapport à la quantité de précurseur (La,Ce,Tb)PO$_4$. Afin de faciliter le délitage du produit obtenu, celui-ci est ensuite redispersé dans une solution à 5% d'acide nitrique, filtré sur filtre Büchner, puis lavé par 3L d'eau, puis redispersé dans une solution à 5% de potasse, filtré et lavé par 3L d'eau.

Il est ensuite séché à l'étuve, pendant une nuit à 60°C puis tamisé.

Les particules présentent un D$_{50}$ de 7,3 $\mu$m, avec un indice de dispersion de 1,2.

Le rendement de luminescence mesuré à 25°C est de 98% par rapport au produit de l'exemple 2.

La teneur en bore est de 530 ppm et de 44 ppm en lithium.

On donne dans le tableau ci-dessous les variations de brillance.

|  | B$_{25}$ | B$_{200}$ | Variation |
|---|---|---|---|
| Exemple 2 | 100 | 98 | 2% |
| Exemple 3 | 99 | 80 | 19% |
| Exemple 4 | 98 | 91 | 7% |

La mesure de la brillance à 200°C est faite sur un luminophore qui est maintenu à 200°C sur une plaque chauffante (montée en température par paliers de 20°C avec 15 minutes par palier).

**Revendications**

1. Luminophore à base d'un phosphate de lanthane, de cérium et de terbium, **caractérisé en ce que** le phosphate est constitué de particules de taille moyenne d'au plus 4 $\mu$m, **en ce qu'**il présente une teneur en lithium d'au plus 30 ppm, une teneur en bore d'au plus 30 ppm et **en ce que** les brillances $B_{25}$ et $B_{200}$ mesurées pour le luminophore respectivement à 25°C et à 200°C sont telles que $[B_{25} - B_{200}] / B_{25} \leq 0{,}04$.

2. Luminophore selon la revendication 1, **caractérisé en ce qu'**il présente une variation de brillance d'au plus 2%.

3. Luminophore selon la revendication 1 ou 2, **caractérisé en ce que** le phosphate est constitué de particules de taille moyenne d'au plus 3,5 $\mu$m.

4. Luminophore selon l'une des revendications précédentes, **caractérisé en ce que** le phosphate est constitué de particules de taille moyenne comprise entre 2,5 $\mu$m et 4 $\mu$m, plus particulièrement entre 2,5 $\mu$m et 3,5 $\mu$m.

5. Luminophore selon l'une des revendications précédentes, **caractérisé en ce que** le phosphate est constitué de particules présentant un indice de dispersion d'au plus 0,7.

6. Luminophore selon l'une des revendications précédentes, **caractérisé en ce que** le phosphate de lanthane, de cérium et de terbium répond à la formule $(La_xCe_yTb_z)PO_4$ dans laquelle x, y et z vérifient les formules :

$$x + y + z = 1$$

$$0{,}2 \leq y \leq 0{,}45$$

$$0{,}1 \leq z \leq 0{,}2$$

7. Procédé de préparation d'un luminophore selon l'une des revendications précédentes, **caractérisé en ce qu'**il comprend les étapes suivantes :

   a) on introduit, en continu et sous agitation, une première solution contenant des sels solubles des éléments lanthane, cérium et terbium dans une seconde solution contenant des ions phosphates et présentant un pH initial inférieur à 2, ce par quoi on forme un précipité, et on contrôle au cours de l'introduction de la première solution dans la seconde, le pH du milieu de précipitation à une valeur constante et inférieure à 2;
   b) on récupère le précipité ainsi obtenu;
   c) on calcine le précipité à une température d'au plus 1000°C;
   d) on traite thermiquement ce précipité sous atmosphère réductrice, en présence de tétraborate de lithium ($Li_2B_4O_7$) dans une quantité massique d'au plus 0,2%, à une température comprise entre 1050°C et 1150°C et sur une durée comprise entre 2 heures et 4 heures.

8. Procédé selon la revendication 7, **caractérisé en ce que** le pH du milieu de précipitation est maintenu constant à une valeur comprise entre 1 et 2.

9. Procédé selon la revendication 7 ou 8, **caractérisé en ce que** le contrôle du pH du milieu de précipitation est réalisé par addition d'un composé basique, plus particulièrement l'hydroxyde d'ammonium.

10. Procédé selon l'une des revendications 7 à 9, **caractérisé en ce que** les ions phosphates de la seconde solution précitée sont sous forme d'une solution d'acide phosphorique.

11. Procédé selon l'une des revendications 7 à 10, **caractérisé en ce que** la quantité de tétraborate de lithium est comprise entre 0,1% et 0,2%.

12. Procédé selon l'une des revendications 7 à 11, **caractérisé en ce que** le produit issu de l'étape d) est redispersé dans l'eau à une température d'au moins 30°C ce par quoi on obtient une suspension, puis maintenu en suspension et enfin séparé du milieu liquide de ladite suspension.

13. Utilisation d'un luminophore selon l'une des revendications 1 à 6, dans des dispositifs à excitation UV, notamment dans des lampes trichromatiques, notamment à vapeur de mercure, les lampes de rétro-éclairage de systèmes à cristaux liquides, les écrans plasma, les lampes à excitation Xénon, les dispositifs à excitation par diodes électroluminescentes et les systèmes de marquage à excitation UV.

14. Dispositif luminescent comprenant un luminophore selon l'une des revendications 1 à 6 à titre de source de luminescence verte.

15. Dispositif luminescent selon la revendication 14, **caractérisé en ce qu'**il s'agit d'un dispositif à excitation UV, notamment de lampes trichromatiques, notamment à vapeur de mercure, de lampes de rétro-éclairage, de systèmes à cristaux liquides, d'écrans plasma, de lampes à excitation Xénon, de dispositifs à excitation par diodes électroluminescentes et de systèmes de marquage à excitation UV.

**Patentansprüche**

1. Luminophor auf Basis eines Phosphats von Lanthan, Cer und Terbium, **dadurch gekennzeichnet, dass** das Phosphat aus Teilchen mit einer mittleren Größe von höchstens 4 $\mu$m besteht, dadurch, dass er einen Gehalt an Lithium von höchstens 30 ppm, einen Gehalt an Bor von höchstens 30 ppm aufweist, und dadurch, dass die für den Luminophor bei 25°C bzw. 200°C gemessenen Leuchtkräfte $B_{25}$ und $B_{200}$ derart sind, dass gilt $[B_{25} - B_{200}]/B_{25} \leq 0,04$.

2. Luminophor nach Anspruch 1, **dadurch gekennzeichnet, dass** er eine Leuchtkraftänderung von höchstens 2% aufweist.

3. Luminophor nach Anspruch 1 oder 2, **dadurch gekennzeichnet, dass** das Phosphat aus Teilchen mit einer mittleren Größe von höchstens 3,5 $\mu$m besteht.

4. Luminophor nach einem der vorhergehenden Ansprüche, **dadurch gekennzeichnet, dass** das Phosphat aus Teilchen mit einer mittleren Größe zwischen 2,5 $\mu$m und 4 $\mu$m, besonders zwischen 2,5 $\mu$m und 3,5 $\mu$m besteht.

5. Luminophor nach einem der vorhergehenden Ansprüche, **dadurch gekennzeichnet, dass** das Phosphat aus Teilchen besteht, die einen Dispersionsindex von höchstens 0,7 aufweisen.

6. Luminophor nach einem der vorhergehenden Ansprüche, **dadurch gekennzeichnet, dass** das Phosphat von Lanthan, Cer und Terbium der Formel $(La_xCe_yTb_z)PO_4$ gehorcht, worin x, y und z den folgenden Formeln genügen:

$$x + y + z = 1$$

$$0,2 \leq y \leq 0,45$$

$$0,1 \leq z \leq 0,2$$

7. Verfahren zur Herstellung eines Luminophors Herstellung nach einem der vorhergehenden Ansprüche, **dadurch gekennzeichnet, dass** es die folgenden Schritte umfasst:

a) Einbringen im Durchlauf und unter Rühren einer ersten Lösung, die lösliche Salze der Elemente Lanthan, Cer und Terbium enthält, in eine zweite Lösung, die Phosphationen enthält und einen anfänglichen pH-Wert von unter 2 aufweist, wodurch sich ein Niederschlag bildet, und Regeln des pH-Werts des Ausfällungsmediums auf einen konstanten Wert von unter 2 während des Einbringens der ersten Lösung in die zweite;
b) Gewinnen des so erhaltenen Niederschlags;
c) Kalzinieren des Niederschlags bei einer Temperatur von höchstens 1000°C;
d) thermische Behandlung des Niederschlags unter einer reduzierenden Atmosphäre in Gegenwart von Lithiumtetraborat ($Li_2B_4O_7$) in einem Gewichtsanteil von höchstens 0,2% bei einer Temperatur zwischen 1050°C und 1150°C und über einen Zeitraum zwischen 2 Stunden und 4 Stunden.

8. Verfahren nach Anspruch 7, **dadurch gekennzeichnet, dass** der pH-Wert des Ausfällungsmediums bei einem Wert zwischen 1 und 2 konstant gehalten wird.

9. Verfahren nach Anspruch 7 oder 8, **dadurch gekennzeichnet, dass** die Regelung des pH-Werts des Ausfällungsmediums durch Zugabe einer basischen Verbindung, insbesondere Ammoniumhydroxid, durchgeführt wird.

10. Verfahren nach einem der Ansprüche 7 bis 9, **dadurch gekennzeichnet, dass** die Phosphationen der vorstehenden zweiten Lösung die Form einer Phosphorsäurelösung haben.

11. Verfahren nach einem der Ansprüche 7 bis 10, **dadurch gekennzeichnet, dass** die Menge an Lithiumtetraborat zwischen 0,1% und 0,2% beträgt.

12. Verfahren nach einem der Ansprüche 7 bis 11, **dadurch gekennzeichnet, dass** das aus Schritt d) erhaltene Produkt in Wasser bei einer Temperatur von mindestens 30°C redispergiert wird, wodurch man eine Suspension erhält, und dann in Suspension gehalten und schließlich von dem flüssigen Medium der Suspension abgetrennt wird.

13. Verwendung eines Luminophors nach einem der Ansprüche 1 bis 6 in UV-Anregungsvorrichtungen, insbesondere in trichromatischen Lampen, insbesondere Quecksilberdampflampen, Hintergrundbeleuchtungen von Flüssigkristallsystemen, Plasmabildschirmen, Xenonanregungslampen, Leuchtdiodenanregungsvorrichtungen und UV-Anregungs-Markierungssystemen.

14. Lumineszierende Vorrichtung, umfassend einen Luminophor nach einem der Ansprüche 1 bis 6 als Quelle für grüne Lumineszenz.

**15.** Lumineszierende Vorrichtung nach Anspruch 14, **dadurch gekennzeichnet, dass** es sich um eine UV-Anregungsvorrichtung, insbesondere trichromatische Lampen, insbesondere Quecksilberdampflampen, Hintergrundbeleuchtungen von Flüssigkristallsystemen, Plasmabildschirme, Xenonanregungslampen, Leuchtdiodenanregungsvorrichtungen und UV-Anregungs-Markierungssysteme handelt.

**Claims**

**1.** Phosphor based on a lanthanum cerium terbium phosphate, **characterized in that** the phosphate consists of particles having an average size of not more than 4 $\mu$m, **in that** it has a lithium content of not more than 30 ppm and a boron content of not more than 30 ppm, and **in that** the brightnesses $B_{25}$ and $B_{200}$ measured for the phosphor at 25°C and at 200°C respectively are such that $[B_{25}-B_{200}]/B_{25} \leq 0.04$.

**2.** Phosphor according to Claim 1, **characterized in that** it has a variation in brightness of not more than 2%.

**3.** Phosphor according to Claim 1 or 2, **characterized in that** the phosphate consists of particles having an average size of not more than 3.5 $\mu$m.

**4.** Phosphor according to any of the preceding claims, **characterized in that** the phosphate consists of particles having an average size of between 2.5 $\mu$m and 4 $\mu$m, more particularly between 2.5 $\mu$m and 3.5 $\mu$m.

**5.** Phosphor according to any of the preceding claims, **characterized in that** the phosphate consists of particles having a dispersion index of not more than 0.7.

**6.** Phosphor according to any of the preceding claims, **characterized in that** the lanthanum cerium terbium phosphate conforms to the formula $(La_xCe_yTb_z)PO_4$ in which x, y and z satisfy the following formulae:

$$x + y + z = 1$$

$$0.2 \leq y \leq 0.45$$

$$0.1 \leq z \leq 0.2$$

**7.** Process for preparing a phosphor according to any of the preceding claims, **characterized in that** it comprises the following steps:

a) introducing, continuously and with stirring, a first solution comprising soluble salts of the elements lanthanum, cerium and terbium into a second solution comprising phosphate ions and having an initial pH of less than 2, thereby forming a precipitate, and, during the introduction of the first solution into the second, maintaining the pH of the precipitation medium at a constant value of less than 2;
b) recovering the resulting precipitate;
c) calcining the precipitate at a temperature of not more than 1000°C;
d) heat-treating this precipitate under a reducing atmosphere, in the presence of lithium tetraborate ($Li_2B_4O_7$) in a quantity by mass of not more than 0.2%, at a temperature of between 1050°C and 1150°C and over a time of between 2 hours and 4 hours.

**8.** Process according to Claim 7, **characterized in that** the pH of the precipitation medium is held constant at a value of between 1 and 2.

**9.** Process according to Claim 7 or 8, **characterized in that** the pH of the precipitation medium is maintained by addition of a basic compound, more particularly ammonium hydroxide.

**10.** Process according to any of Claims 7 to 9, **characterized in that** the phosphate ions of the aforesaid second solution are in the form of a phosphoric acid solution.

**11.** Process according to any of Claims 7 to 10, **characterized in that** the quantity of lithium tetraborate is between 0.1% and 0.2%.

**12.** Process according to any of Claims 7 to 11, **characterized in that** the product obtained from step d) is redispersed in water at a temperature of at least 30°C, to give a suspension, then held in suspension and lastly separated from the liquid medium of said suspension.

**13.** Use of a phosphor according to any of Claims 1 to 6 in UV excitation devices, especially trichromatic lamps, especially mercury vapor lamps, lamps for backlighting liquid-crystal systems, plasma screens, xenon excitation lamps, light-emitting diode excitation devices and UV excitation marking systems.

**14.** Luminescent device comprising a phosphor according to any of Claims 1 to 6 as green luminescence source.

**15.** Luminescent device according to Claim 14, **characterized in that** it is a UV excitation device, especially trichromatic lamps, especially mercury vapor lamps, lamps for backlighting liquid-crystal systems, plasma screens, xenon excitation lamps, light-emitting diode excitation devices and UV excitation marking systems.